## Europäisches Patentamt

## European Patent Office

## Office européen des brevets

(19)

(11) Veröffentlichungsnummer: **0 064 188**
**B1**

(12) ## EUROPÄISCHE PATENTSCHRIFT

(45) Veröffentlichungstag der Patentschrift:
**19.11.87**

(51) Int. Cl.⁴: **G 11 C 11/40**

(21) Anmeldenummer: **82103173.9**

(22) Anmeldetag: **15.04.82**

(54) **Monolithisch integriertes Treiberschaltungssystem für die Wortleitungen eines Matrixspeichers.**

(30) Priorität: **05.05.81 US 260576**

(43) Veröffentlichungstag der Anmeldung:
**10.11.82 Patentblatt 82/45**

(45) Bekanntmachung des Hinweises auf die Patenterteilung:
**19.11.87 Patentblatt 87/47**

(84) Benannte Vertragsstaaten:
**DE FR GB**

(56) Entgegenhaltungen:
**US - A - 4 156 941**

(73) Patentinhaber: **International Business Machines Corporation, Old Orchard Road, Armonk, N.Y. 10504 (US)**

(72) Erfinder: **Houghton, Russell James, 40 Pleasant Street, Essex Junction Vermont 05452 (US)**

(74) Vertreter: **Neuland, Johannes, Dipl.-Ing., Schönaicher Strasse 220, D-7030 Böblingen (DE)**

EP 0 064 188 B1

**Beschreibung**

Die Erfindung bezieht sich auf ein monolithisch integriertes Treiberschaltungssystem für die Wortleitungen eines Matrixspeichers.

Die Zellen einer Speicheranordnung werden im allgemeinen in Zeilen und Spalten angeordnet, wobei jede Zeile von Speicherzellen mit einer eigenen Wortleitung gekoppelt ist und jede Spalte von Speicherzellen an eine Abfühlleitung für ein Bit oder an ein Paar von Abfühlleitungen angeschlossen ist. Darüber hinaus wird die Spannung auf oder der Strom in jeder Wortleitung gesteuert durch getrennte Worttreiberschaltungen, wie sie in dem US Patent 3 863 229 dargestellt und beschrieben sind. Obwohl das in diesem Patent nicht dargestellt ist, ist jede Treiberschaltung über einen eigenen Widerstand mit einer Klemme der Spannungsversorgung verbunden. Es ist bekannt, dass übliche Dekodierschaltungen verwendet werden, um nur eine aus einer Vielzahl von Wortleitungen zu einem Zeitpunkt auszuwählen. Es ist ebenfalls bekannt, dass vor der endgültigen Auswahl einer der Wortleitungen der Dekodierer dazu neigt, mehreren Treiberschaltungen ein niedriges Potential zuzuführen anstatt nur der einen Treiberschaltung, die mit der gewünschten Wortleitung gekoppelt ist. Diese Wirkungsweise ruft nicht nur Verzögerungen bei der endgültigen Auswahl einer Wortleitung hervor, sondern sie kann auch tatsächlich eine falsche Auswahl oder die Auswahl einer unerwünschten Wortleitung der Speicheranordnung verursachen.

Hier will die Erfindung Abhilfe schaffen. Die Erfindung, wie sie in den Ansprüchen gekennzeichnet ist, löst die Aufgabe, ein verbessertes System zum Auswählen der Wortleitungen einer Speicheranordnung anzugeben, das schneller als bekannte Systeme arbeitet und bei denen die Wahrscheinlichkeit für das fehlerhafte Auswählen einer Wortleitung gegenüber bekannten System verringert ist.

Im folgenden wird die Erfindung in Verbindung mit den Zeichnungen näher erläutert.

Von den Zeichnungen zeigt:

Fig. 1 ein erfindungsgemässes Wortleitungs-Treibersystem und

Fig. 2 eine Reihe von Kurven, die Strom- und Spannungsverläufe in dem System nach Fig. 1 darstellen.

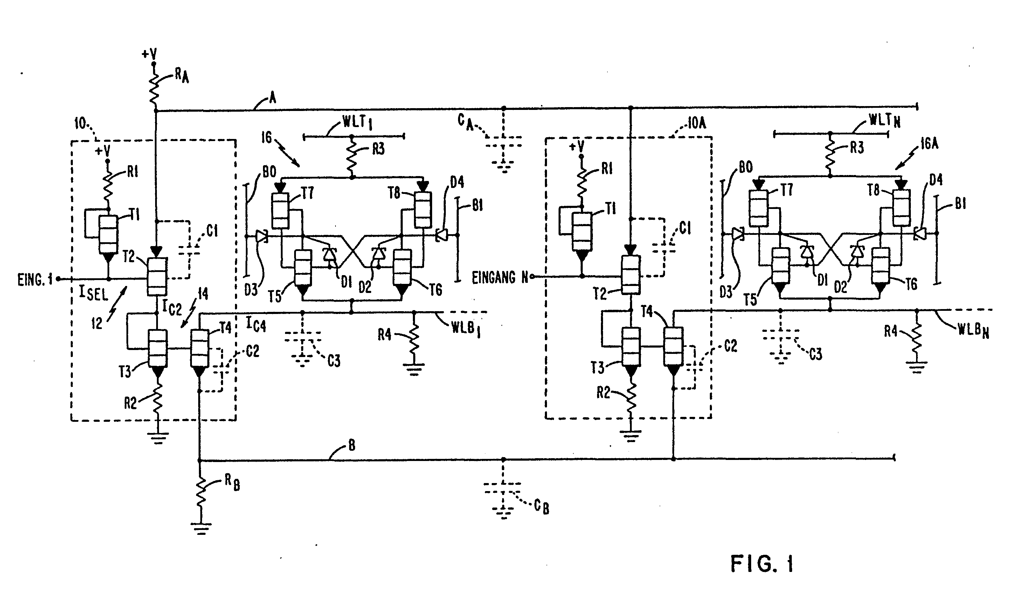

In Fig. 1 ist ein Ausführungsbeispiel eines erfindungsgemässen Wortleitungs-Treibersystems für eine Speicheranordnung dargestellt. Dieses System ist mit einer ersten Treiberschaltung 10 versehen, die einen ersten Stromverstärker 12 enthält, bei dem ein NPN-Transistor T1 und ein dazu in Reihe liegender Widerstand R1 zwischen einer ersten Klemme +V einer Betriebsspannungsquelle und einer Eingangsklemme 1 angeordnet sind, wobei der Emitter des Transistors T1 an die Eingangsklemme 1 angeschlossen ist und seine Basis und sein Kollektor miteinander verbunden sind. Die Basis eines PNP-Transistors T2, der eine durch den Kondensator C1 angedeutete Sperrschichtkapazität zwischen seinem Emitter und seiner Basis aufweist, ist mit dem Emitter des Transistors T1 verbunden. Die erste Treiberschaltung 10 ist auch mit einem zweiten Stromverstärker 14 versehen, dessen NPN-Transistoren T3 und T4 an ihren Basen miteinander verbunden sind. Der Kollektor und die Basis des Transistors T3 sind miteinander und mit dem Kollektor des PNP-Transistors T2 des ersten Stromverstärkers 12 verbunden. Der Emitter des NPN-Transistors T3 ist über einen zweiten Widerstand R2 an das Massepotential angeschlossen und die Kapazität der Basis-Emitter-Sperrschicht des Transistors T4 ist durch den Kondensator C2 angedeutet.

Die erste Treiberschaltung 10 ist über den Emitter des PNP-Transistors T2 und einem ersten gemeinsamen Widerstand $R_A$ an die erste Klemme +V einer Betriebsspannungsquelle angeschlossen und über den Emitter des NPN-Transistors T4 des zweiten Verstärkers 14 und einem zweiten gemeinsamen Widerstand $R_B$ an die zweite, an Masse liegende Klemme der Betriebsspannungsquelle angeschlossen. Der Kollektor des NPN-Transistors T4 ist mit einer unteren Wortleitung $WLB_1$ verbunden, an die eine Reihe von Speicherzellen, z.B. 64, der Speicheranordnung angeschlossen sind, von denen nur eine Speicherzelle 16 in Fig. 1 dargestellt ist. Die Speicherzelle 16, die der in dem vorher genannten US Patent beschriebenen entspricht, enthält ein Paar kreuzgekoppelter NPN-Transistoren T5 und T6 und ein Paar von PNP-Lasttransistoren T7 und T8, die mit den kreuzgekoppelten Transistoren T5 und T6 verbunden sind. Die Emitter der kreuzgekoppelten Transistoren T5 und T6 sind miteinander und mit der unteren Wortleitung $WLB_1$ verbunden. Die Emitter der Lasttransistoren T7 und T8 sind ebenfalls miteinander und über einen Widerstand R3 der Speicherzelle mit einer oberen Wortleitung WLT1 verbunden. Die untere Wortleitung WLB1 ist über einen Widerstand R4 und eine Kapazität C3, die die Ersatzkapazität aller an die Wortleitung WLB1 angeschlossenen Speicherzellen darstellt, an das Massepotential angeschlossen. Die obere Wortleitung WLT1 ist über einen oder mehrere nichtdargestellten Widerstände in üblicher Weise mit einer Spannungsquelle verbunden. Erste und zweite Schottky-Klemmdioden D1 und D2 verbinden jeweils die Basis und den Kollektor der kreuzgekoppelten Transistoren T5 und T6. Ein Paar von Bitabfühlleitungen B0 und B1 sind über dritte und vierte, als Schottky-Dioden D3 und D4 dargestellte Schalter mit der Speicherzelle 16 verbunden.

Eine zweite Wortleitungs-Treiberschaltung 10A die der ersten gleicht und auch in Fig. 1 dargestellt ist, ist über den Emitter des PNP-Transistors T2 ihres ersten Verstärkers 12 und den ersten gemeinsamen Widerstand $R_A$ an die erste Klemme +V der Betriebsspannungsquelle und über den Emitter des NPN-Transistors T4 ihres zweiten Verstärkers 14 über den zweiten gemeinsamen Widerstand $R_B$ mit der zweiten auf Masse liegenden Klemme der Betriebsspannungsquelle angeschlossen. Die zweite Treiberschaltung 10A ist auch über die Basis ihres PNP-Transistors T2 an eine Eingangsklemme N und über den Kollektor ihres NPN-Transistors T4 an eine andere untere Wortleitung $WLB_N$ angeschlossen. Eine Reihe von Speicherzellen sind mit der unteren Wortleitung $WLB_N$ und einer oberen Wortleitung $WLT_N$ verbunden, von denen nur die Speicherzelle 16A dargestellt ist. Mit der Speicherzelle 16A ist ein anderes Paar von Bitabfühlleitungen B0 und B1 verbunden.

Es sei bemerkt, dass der PNP-Transistor T2 der zweiten Wortleitungs-Treiberschaltung 10A auch eine Basis-Emitter-Sperrschichtkapazität zwischen Emitter und Basis aufweist, die durch die Kapazität C1 dargestellt ist, die mit der entsprechenden Sperrschichtkapazität der ersten Wortleitungs-Treiberschaltung 10 über eine erste gemeinsame Leitung A verbunden ist. Da die erste und zweite Wortleitungs-Treiberschaltungen 10 und 10A nur zwei von sehr viel mehr solcher Treiberschaltungen, z.B. 100 darstellen, ist ersichtlich, dass die Leitung A eine stark kapazitiv belastete Leitung ist, deren Kapazität durch die Kapazität $C_A$ in Fig. 1 dargestellt ist. In gleicher Weise ist eine zweite gemeinsame Leitung B, die mit den Emittern der NPN-Transistoren T4 der Wortleitungs-Treiberschaltungen 10 und 10A verbunden ist, eine hoch kapazitiv belastete Leitung, da jede der parallel angeordneten Basis-Emitter-Sperrschichten der NPN-Transistoren T4 eine Kapazität darstellt. Die Kapazität der Leitung B ist in Fig. 1 mit $C_B$ bezeichnet.

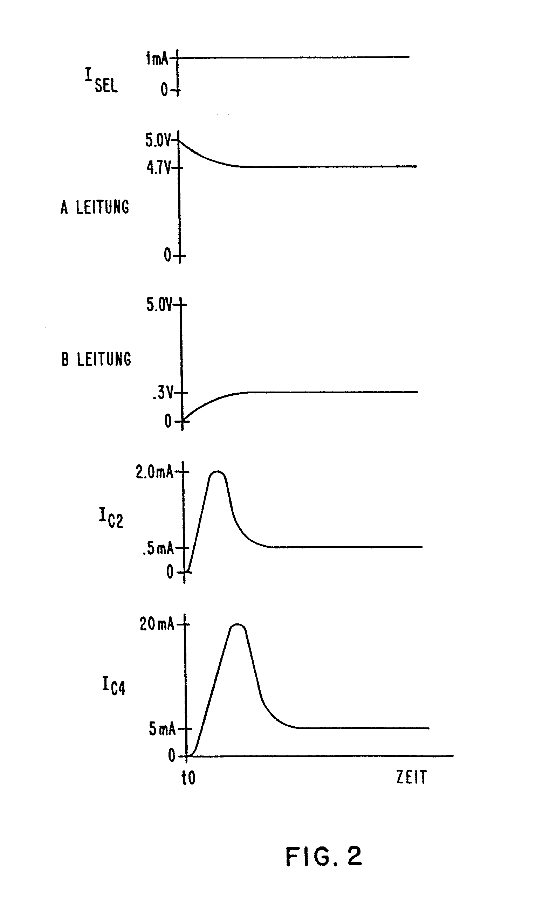

Zum besseren Verständnis der Wirkungsweise des in Fig. 1 dargestellten erfindungsgemässen Systems wird auf die in Fig. 2 dargestellten Kurvenverläufe Bezug genommen, die die Strom- und Spannungsverläufe in dem System nach Fig. 1 darstellen. Vor dem Zeitpunkt $t_0$, wenn das System im Wartezustand ist, ist der Strom $I_{SEL}$ an den Eingangsklemmen 1 und N null und daher fliesst kein Strom durch die PNP-Transistoren T2 noch durch die NPN-Transistoren T4 der Treiberschaltungen 10 und 10A. Daher ist die kapazitive Leitung A, d.h. die Kapazität $C_A$ über den ersten gemeinsamen Widerstand $R_A$ auf die Spannung +V aufgeladen und die kapazitive Leitung B, d.h. die Kapazität $C_B$, ist über den zweiten gemeinsamen Widerstand $R_B$ auf nahezu 0 Volt entladen. Die Wortleitungen $WLB_1$ und $WLB_N$ werden über die Speicherzellen, die mit diesen Wortleitungen verbunden sind, auf eine für den Wartezustand vorgegebene Spannung aufgeladen.

Zum Zeitpunkt $t_0$, wenn z.B. die Treiberschaltung 10 ausgewählt wird, steigt der Strom $I_{SEL}$ auf 1 mA an, wobei nahezu der gesamte Strom durch den PNP-Transistor T2 der Schaltung 10 fliesst, da der Emitter des Transistors T2 an einer Spannung von +V liegt aufgrund der grossen geladenen Kapazität $C_A$, während die Spannung am Kollektor des NPN-Transistors T1 einen Wert besitzt, der der um den Spannungsabfall an dem gemeinsamen Widerstand R1 verringerten Spannung von +V entspricht. Bevor ein merklicher Strom durch den Transistor T1 fliessen kann, muss die grosse Kapazität $C_A$ durch den Emitterstrom des PNP-Transistors T2 entladen werden. Der Strom $I_{SEL}$ verursacht einen grossen Überschussstrom $I_{C2}$ im Kollektor des PNP-Transistors T2, wie das in Fig. 2 der Zeichnung dargestellt ist. Dieser hohe Strom $I_{C2}$ schaltet die NPN-Transistoren T3 und T4 des zweiten Stromverstärkers 14 ein, was einen noch höheren den Kollektor des NPN-Transistors T4 durchfliessenden Überschussstrom $I_{C4}$ verursacht, der die ausgewählte untere Wortleitung $WLB_1$ entlädt. Das Überschwingen des Kollektorstromes $I_{C4}$ ist besonders stark, da der zweite Stromverstärker 14 mit dem Überschussstrom $I_{C2}$ gespeist wird, und der zweite Stromverstärker 14 in Verbindung mit der zweiten grossen Kapazität $C_B$ so entworfen wurde, dass er seinen Überschussstrom in der gleichen Weise erzeugt, wie der Überschussstrom des ersten Stromverstärkers 12 in Verbindung mit der ersten grossen Kapazität $C_A$ erzeugt wurde. Daher wird mit dieser Anordnung in der Treiberschaltung 10 ein das Überschwingen verstärkender Effekt hervorgerufen. Diese Überschwingeigenschaft des Treiberstroms der Wortleitung am Kollektor des NPN-Transistors T4 sorgt zusätzlich für ein schnelleres Entladen und Auswählen der Wortleitungen WLB1.

Nach dem Abklingen des Überschussstromes fällt am ersten Widerstand R1 eine Spannung ab, die etwa gleich ist der Spannung, die an dem ersten gemeinsamen Widerstand $R_A$ abfällt, wenn die Kapazität $C_A$ im wesentlichen entladen ist, wobei angenommen ist, dass die Transistoren T1 und T2 die gleiche Basis-Emitterspannung $V_{BE}$ besitzen.

Der Kollektorstrom $I_{C2}$ an dem PNP-Transistor T2 ist gleich $I_{SEL} \cdot R1/R_A$, der den zweiten Stromverstärker 14 in der gleichen Weise steuert wie der Strom $I_{SEL}$ den ersten Stromverstärker 12. Der Ausgangsstrom am Kollektor des NPN-Transistors T4, der die untere Wortleitung $WLB_1$ speist ist dann ungefähr gleich $I_{SEL} \cdot R1/R_A \cdot R2/R_B$, wobei zwischen Eingang und Ausgang eine Verstärkung auftritt, die auf den Widerstandsverhältnissen basiert.

Die erste gemeinsame Kapazität $C_A$ ist zum besseren Verständnis dargestellt worden als zwischen der ersten gemeinsamen Leitung A und einem Punkt mit Massepotential angeschlossen. In der Praxis jedoch kann ein Punkt mit einem anderen Bezugspotential als dem Massepotential benutzt werden, wie z.B. die Eingangsklemmen, die mit der Basis des PNP-Transistors T2 verbunden sind. Es sei bemerkt, dass, wenn das erwünscht ist, auch eine oder beide der Leitungen A und B mit einem diskreten Kondensator verbunden sein können.

Es ist ersichtlich, dass, sobald die Kapazität C3 der Wortleitung auf einen vorgegebenen Auswählpegel entladen ist, der auch zu einem Zeitpunkt erreicht werden kann, bevor der Strom $I_{C4}$ seinen Spitzenwert erreicht, der Schreib- oder Leseteil eines Zugriffszyklus' beginnen kann.

Ein zusätzlicher Vorteil der gemeinsamen Leitungen A und B ist das Rückkehren in den Ausgangszustand nach fehlerhaften Auswählvorgängen. Wie bekannt, haben die Dekodierer zu Beginn die Neigung, das Potential mehrerer Eingänge abzusenken, z.B. durch Stromteilung, bevor die gewünschte Wortleitung ausgewählt ist. Irgendeiner oder mehrere Treiberschaltungen, die fälschlicherweise ausgewählt wurden, gelangen durch das Abnehmen der Spannung auf der ersten gemeinsamen Leitung A in den Ausgangszustand zurück, wenn diese Leitung entladen wird und die PNP-Transistoren T2 nichtleitend werden und durch das Anwachsen der Spannung in der zweiten gemeinsamen Leitung B, wenn sie aufgeladen wird und dadurch den NPN-Transistor T4 in den nichtausgewählten Treiberschaltungen abschaltet.

Obgleich in Fig. 1 ein System gemäss der Erfindung dargestellt wurde, das eine Treiberschaltung besitzt, bei der ein PNP-Transistor T2 mit der ersten gemeinsamen Leitung A verbunden ist, versteht es sich, dass, wenn das erwünscht ist, die Treiberschaltungen auch einen NPN-Transistor mit einer Sperrschichtkapazität enthalten können, die mit der ersten gemeinsamen Leitung A verbunden ist. In gleicher Weise kann ein PNP-Transistor mit einer Sperrschichtkapazität, die mit der zweiten gemeinsamen Leitung B gekoppelt ist, in den Treiberschaltungen nach der Erfindung verwendet werden. Es versteht sich, dass andere Speicherzellen als die in Fig. 1 dargestellten in einer Speicheranordnung verwendet werden können, die mit den Wortleitungen wie z.B. den Wortleitungen $WLB_1$ und $WLB_N$ verbunden ist.

Es ist ersichtlich, dass einfach durch geeignetes Verbinden eine Anzahl von Treiberschaltungen, die dazu dienen, eine gleiche Anzahl von Wortleitungen zu steuern, ein Wortleitungstreibersystem für eine Speicheranordnung geschaffen wird, die ein wesentlich verbessertes Betriebsverhalten bezüglich der Leistung besitzt und das gegen falsche Auswählvorgänge schützt. Dieses System benutzt einen einzigen Widerstand $R_A$, um alle Treiberschaltungen mit der Klemme +V der Betriebsspannungsquelle zu verbinden und benutzt einen einzigen Widerstand $R_B$, um alle diese Treiberschaltungen mit dem Massepotential zu verbinden, um die genannten Ergebnisse zu erreichen.

### Patentansprüche

1. Monolithisch integriertes Treiberschaltungssystem für die Wortleitungen eines Matrixspeichers, dadurch gekennzeichnet, dass alle Wortleitungsschalter (10, 10A) über eine gemeinsame erste Leitung (A) miteinander und über einen gemeinsamen ersten Widerstand ($R_A$) mit dem ersten Pol sowie über eine gemeinsame zweite Leitung (B) und einen gemeinsamen zweiten Widerstand ($R_B$) mit dem zweiten Pol der Betriebsspannungsquelle verbunden sind.

2. Treiberschaltungssystem nach Anspruch 1, dadurch gekennzeichnet, dass jeder Wortleitungsschalter ein erstes (T2) und ein zweites (T4) aktives Halbleiter-Schaltungselement enthält, von denen das zweite vom ersten gesteuert wird.

3. Treiberschaltungssystem nach den Ansprüchen 1 und 2, dadurch gekennzeichnet, dass das erste und zweite aktive Halbleiter-Schaltungselement Transistoren von entgegengesetztem Leitfähigkeitstyp sind.

4. Treiberschaltungssystem nach den Ansprüchen 1 bis 3, dadurch gekennzeichnet, dass die Transistoren als Stromverstärker dienen.

5. Treiberschaltung nach den Ansprüchen 1 bis 4, dadurch gekennzeichnet, dass die Leitungskapazität der ersten und zweiten gemeinsamen Leitung (A, B) durch die Kapazitäten der Basis-Emitter-Sperrschichten der Transistoren vergrössert ist.

6. Treiberschaltungssystem nach den Ansprüchen 1 bis 5, dadurch gekennzeichnet, dass zu Beginn der Selektion eines Wortleitungsschalters dessen erstes aktives Halbleiter-Schaltungselement (T2) von einem Überschussstrom durchflossen wird, der durch das Entladen der vergrösserten Kapazität ($C_A$) der ersten gemeinsamen Leitung (A) bedingt ist und der nach Verstärkung in dem zweiten aktiven Halbleiter-Schaltungselement (T4) ein schnelles Entladen der Kapazität der ausgewählten Wortleitung und damit deren Selektion sicherstellt.

7. Treiberschaltungssystem nach den Ansprüchen 1 bis 6, dadurch gekennzeichnet, dass beim Auswählen eines Wortleitungsschalters die Kapazität ($C_A$) der ersten gemeinsamen Leitung (A) entladen und dadurch ihr Potential abgesenkt und die Kapazität ($C_B$) der zweiten gemeinsamen Leitung (B) aufgeladen und damit ihr Potential angehoben wird, wodurch ein Aktivieren nicht ausgewählter Wortleitungsschalter verhindert wird.

### Claims

1. Monolithically integrated driver circuit system for the word lines of a matrix storage, characterized in that all word line switches (10, 10A) are interconnected via a common first line (A), and via a common first resistor ($R_A$) to the first pole as well as via a common second line (B) and a common second resistor ($R_B$) to the second pole of the operating voltage source.

2. Driver circuit system as claimed in claim 1, characterized in that each word line switch comprises a first (T2) and a second (T4) active semiconductor switching element, the second element being controlled by the first one.

3. Driver circuit system as claimed in any one of claims 1 and 2, characterized in that the first and the second active semiconductor circuit elements are transistors of opposite conductivity.

4. Driver circuit system as claimed in any one of claims 1 to 3, characterized in that the transistors are used as current amplifiers.

5. Driver circuit as claimed in any one of claims 1 to 4, characterized in that the load capacity of the first and second common line (A, B) is increased by the capacities of the base-emitter junctions of the transistors.

6. Driver circuit as claimed in any one of claims 1 to 5, characterized in that in the begining of the selection of a word line switch the first active semiconductor element (T2) of said switch carries a surplus current which is due to the discharge of the increased capacity ($C_A$) of the first common line (A), and which after amplification in the second active semiconductor circuit element (T4) ensures a speedy discharge of the capacity of the word line selected, and thus of its selection.

7. Driver circuit system as claimed in any one of claims 1 to 6, characterized in that upon the selection of a word line switch the capacity ($C_A$) of the first common line (A) is discharged and thus its potential is decreased, and the capacity ($C_B$) of the second common line (B) is charged and thus the potential of the second common line (B) is increased, thereby preventing an activation of the non-selected word line switches.

**Revendications**

1. Circuit d'attaque intégré de façon monolithique pour les lignes de mots d'une mémoire matricielle, caractérisé par le fait que tous les commutateurs de ligne de mots (10, 10A) sont reliés par une première ligne (A) commune les uns aux autres et par une première résistance ($R_A$) commune au premier pôle, ainsi que par une deuxième ligne (B) commune et une deuxième résistance ($R_B$) commune au deuxième pôle de la source de tension de service.

2. Circuit d'attaque selon la revendication 1, caractérisé par le fait que chaque commutateur de ligne de mots contient un premier (T2) et un second (T4) élément actif de commutation à semiconducteur, éléments dont le second est commandé par le premier.

3. Circuit d'attaque selon les revendications 1 et 2, caractérisé par le fait que le premier et le second élément actif de commutation à semiconducteur sont des transistors de types de conductibilité opposés.

4. Circuit d'attaque selon les revendications 1 à 3, caractérisé par le fait que les transistors servent d'amplificateurs de courant.

5. Circuit d'attaque selon les revendications 1 à 4, caractérisé par le fait que la capacité de ligne de la première et de la deuxième lignes communes (A, B) est augmentée par les capacités des couches d'arrêt base-émetteur des transistors.

6. Circuit d'attaque selon les revendications 1 à 5, caractérisé par le fait que, au début de la sélection d'un commutateur de ligne de mots, le premier élément (T2) actif de commutation à semiconducteur de ce commutateur est parcouru par un courant excédentaire, qui est dû à la décharge de la capacité ($C_A$) accrue de la première ligne (A) commune et qui, après amplification dans le second élément (T4) actif de commutation à semiconducteur, assure une décharge rapide de la capacité de la ligne de mots choisie et de la sorte la sélection de cette ligne.

7. Circuit d'attaque selon les revendications 1 à 6, caractérisé par le fait que, lors du choix d'un commutateur de ligne de mots, la capacité ($C_A$) de la première ligne (A) commune est déchargée et, de ce fait, son potentiel est abaissè et la capacité ($C_B$) de la deuxième ligne (B) commune est chargée et, de la sorte, son potentiel est augmenté, ce qui a pour effet d'empêcher l'activation des commutateurs de ligne de mots non choisis.

FIG. 1

FIG. 2